# EUROPÄISCHE PATENTSCHRIFT

(11) **EP 0 787 355 B1**
(45) Veröffentlichungstag und Bekanntmachung des Hinweises auf die Patenterteilung: **30.06.1999**
(21) Anmeldenummer: 95933312.1
(22) Anmeldetag: 05.10.1995
(51) Int. Cl.: H01L 21/8246, H01L 27/112

(54) **VERFAHREN ZUR HERSTELLUNG EINER FESTWERTSPEICHERZELLENANORDNUNG MIT VERTIKALEN MOS-TRANSISTOREN**
PROCESS FOR PRODUCING A READ-ONLY STORAGE CELL ARRANGEMENT WITH VERTICAL MOS TRANSISTORS
PROCEDE DE PRODUCTION D'UN GROUPEMENT DE CELLULES DE MEMOIRE MORTE A TRANSISTORS MOS VERTICAUX

(30) Priorität: 20.10.1994 DE 4437581
(43) Veröffentlichungstag der Anmeldung: 06.08.1997
(73) Patentinhaber: SIEMENS AKTIENGESELLSCHAFT, 80333 München (DE)
(72) Erfinder: RISCH, Lothar, D-85579 Neubiberg (DE); HOFMANN, Franz, D-80995 München (DE); RÖSNER, Wolfgang, D-81739 München (DE); KRAUTSCHNEIDER, Wolfgang, D-83104 Hohenthann (DE)
(86) Internationale Anmeldenummer: DE9501365
(87) Internationale Veröffentlichungsnummer: WO9613064

(56) Entgegenhaltungen:
- US-A- 4 663 644
- US-A- 5 021 355

## Beschreibung

Für viele elektronische Systeme werden Speicher benötigt, in die Daten in digitaler Form fest eingeschrieben sind. Derartige Speicher werden unter anderem als Festwertspeicher, Lesespeicher oder Read-Only-Memory bezeichnet.

Für große Datenmengen, wie insbesondere die digitale Abspeicherung von Musik, werden als Lesespeicher vielfach Kunststoffscheiben, sogenannte Compact Disk, verwendet, die mit Aluminium beschichtet sind. In der Beschichtung weisen diese Scheiben zweierlei punktartige Vertiefungen auf, die den logischen Werten Null und Eins zugeordnet werden. In der Anordnung dieser Vertiefungen ist die Information digital abgespeichert.

Zum Lesen der auf einer Compact Disk gespeicherten Daten wird die Scheibe in einem Lesegerät mechanisch rotiert. Die punktartigen Vertiefungen werden über eine Laserdiode und eine Photozelle abgetastet. Typische Abtastraten sind dabei 2 x 40 kHz. Auf einer Kunststoffscheibe können ca. 4 GBit Informationen gespeichert werden.

Das Lesegerät umfaßt bewegte Teile, die mechanisch verschleißen, die vergleichsweise viel Volumen benötigen und die nur einen langsamen Datenzugriff erlauben. Darüber hinaus ist das Lesegerät empfindlich gegen Erschütterungen und daher für mobile Systeme nur begrenzt geeignet.

Zur Speicherung kleinerer Datenmengen werden vielfach Festwertspeicher auf Halbleiterbasis, insbesondere Silizium, verwendet. Diese sind meist als planare integrierte Siliziumschaltung realisiert, in der als Speicherzellen MOS-Transistoren verwendet werden. Beim Auslesen werden die einzelnen Speicherzellen über die Gateelektrode der MOS-Transistoren, die mit einer Wortleitung verbunden ist, ausgewählt. Der Eingang jedes MOS-Transistors ist mit einer Referenzleitung verbunden, der Ausgang mit einer Bitleitung. Beim Lesevorgang wird bewertet, ob ein Strom durch den Transistor fließt oder nicht. Entsprechend werden die logischen Werte Null und Eins zugeordnet.

Technisch wird die Speicherung von Null und Eins bei diesen Festwertspeichern dadurch bewirkt, daß in Speicherzellen, in denen der dem Zustand "kein Stromfluß durch den Transistor" zugeordnete logische Wert gespeichert ist, kein MOS-Transistor hergestellt wird oder keine leitende Verbindung zur Bitleitung realisiert wird. Alternativ können für die beiden logischen Werte durch MOS-Transistoren realisiert werden, die durch unterschiedliche Implantationen im Kanalgebiet unterschiedliche Einsatzspannungen aufweisen.

Diese bekannten Siliziumspeicher weisen meist einen planaren Aufbau auf. Damit wird pro Speicherzelle ein minimaler Flächenbedarf erforderlich, der bei etwa 6 bis 8 F² liegt, wobei F die in der jeweiligen Technologie kleinste herstellbare Strukturgröße ist. Planare Festwertsiliziumspeicher sind damit bei einer Ein-um-Technologie auf Speicherdichten um 0,14 bit/µm² begrenzt.

Aus US-PS 5 021 355 ist ein Festwertspeicher mit vertikalen MOS-Transistoren bekannt. Zur Herstellung dieses Festwertspeichers wird in einem n-dotierten Substrat eine p-Wanne erzeugt. An der Oberfläche der p-Wanne wird ein n-dotiertes Draingebiet erzeugt. Zur Bildung vertikaler MOS-Transistoren werden Gräben geätzt, die bis in die p-Wanne hineinreichen. Durch Implantation wird am Boden der Gräben ein Sourcegebiet gebildet, das bis an das n-dotierte Substrat angrenzen kann. Entlang der Flanken des Grabens ist ein Kanalgebiet angeordnet. Die Oberfläche des Grabens wird mit einem Gatedielektrikum versehen. Der Graben wird mit einer Gateelektrode aufgefüllt. Benachbarte Speicherzellen werden durch flache Isolationsgebiete, die die Draingebiete durchtrennen und bis in die p-Wanne hineinreichen, gegeneinander isoliert. Null und Eins werden in dieser Anordnung dadurch unterschieden, daß für einen der logischen Werte kein Graben geätzt und kein Transistor hergestellt wird.

Der Erfindung liegt das Problem zugrunde, ein Verfahren zur Herstellung einer Festwertspeicherzellenanordnung auf Halbleiterbasis anzugeben, mit dem Festwertspeicherzellenanordnungen mit erhöhter Speicherdichte erzielt werden und bei dem eine hohe Ausbeute sichergestellt ist.

Dieses Problem wird erfindungsgemäß gelöst durch ein Verfahren gemäß Anspruch 1. Weitere Ausgestaltungen der Erfindung ergeben sich aus den Unteransprüchen.

In dem erfindungsgemäßen Verfahren wird eine Festwertspeicherzellenanordnung hergestellt, die erste Speicherzellen und zweite Speicherzellen umfaßt. Die ersten Speicherzellen, in denen ein erster logischer Wert gespeichert ist, werden durch einen zur Hauptfläche vertikalen MOS-Transistor realisiert. Die zweiten Speicherzellen, in denen ein zweiter logischer Wert gespeichert ist, werden dadurch realisiert, daß kein MOS-Transistor gebildet wird.

Zur Herstellung der Festwertspeicherzellenanordnung werden in einem Siliziumsubstrat, das von einem ersten Leitfähigkeitstyp dotiert ist, ein erstes dotiertes Gebiet und ein zweites dotiertes Gebiet erzeugt. Das erste dotierte Gebiet ist von einem zweiten, zum ersten entgegengesetzten Leitfähigkeitstyp dotiert. Es erstreckt sich über das gesamte Zellenfeld. Es kann sowohl als entsprechend ausgedehnte Wanne als auch als durchgehende Schicht über das gesamte Substrat gebildet sein. Das zweite dotierte Gebiet ist vom ersten Leitfähigkeitstyp dotiert und grenzt an die Hauptfläche des Substrats an.

Es werden mehrere, im wesentlichen parallel verlaufende Isolationsgräben erzeugt. Die Isolationsgräben weisen parallel zur Hauptflache einen streifenförmigen Querschnitt auf und verlaufen über das gesamte Zellenfeld. Die Isolationsgräben reichen von der Hauptflache bis in das vom ersten Leitfähigkeitstyp dotierte Substrat hinein.

Zur Herstellung der ersten Speicherzellen werden Löcher geöffnet, die von der Hauptfläche durch das erste dotierte Gebiet hindurch in das vom ersten Leitfähigkeitstyp dotierte Substrat hineinreichen. Die Oberfläche der Löcher wird mit einem Gatedielektrikum und einer Gateelektrode versehen. Das zweite dotierte Gebiet, das erste dotierte Gebiet und das Substrat wirken dabei als Drain, Kanal und Source.

Zur Herstellung der zweiten Speicherzellen wird an den entsprechenden Orten kein Loch geätzt.

Die Speicherzellen werden vorzugsweise in Zeilen und Spalten angeordnet. Zwischen je zwei Spalten ist jeweils ein Isolationsgraben angeordnet. Quer zu den Isolationsgräben verlaufen Wortleitungen, mit denen die Gateelektroden verbunden sind. Die zweiten dotierten Gebiete, die jeweils zwischen benachbarten Isolationsgraben parallel zu den Isolationsgräben verlaufen, werden als Bitleitungen verwendet. Das Substrat stellt eine gemeinsame Leitung dar, über die eine Betriebsspannung angelegt wird.

Als Halbleitersubstrat wird vorzugsweise ein Substrat aus monokristallinem Silizium verwendet.

Vorzugsweise werden die Löcher zur Bildung der vertikalen MOS-Transistoren jeweils so angeordnet, daß sie die Grenzfläche zwischen einem der Isolationsgräben und dem benachbarten Teil des zweiten dotierten Gebietes überlappen. Dadurch läßt sich die Anordnung mit größerer Packungsdichte erstellen.

Es ist besonders vorteilhaft, die Isolationsgräben in solchen Abständen und mit solchen Breiten zu erzeugen, daß der Abstand zwischen benachbarten Isolationsgräben im wesentlichen gleich der Breite der Isolationsgräben ist. Gleichzeitig werden die Löcher mit einem Querschnitt parallel zur Hauptflache erzeugt, dessen lineare Abmessungen im wesentlichen gleich der Breite der Isolationsgräben ist. Das bedeutet, die Löcher werden zum Beispiel quadratisch mit einer Seitenlänge entsprechend der Breite der Isolationsgräben oder rund mit einem Durchmesser entsprechend der Breite der Isolationsgräben hergestellt. Der Mittelpunkt des Querschnitts der Löcher wird dabei in Bezug auf die Mitte der Isolationsgräben versetzt angeordnet.

Wird in dieser Ausführungsform die Breite der Isolationsgräben gleich der kleinsten, in der verwendeten Technologie herzustellenden Strukturgröße F erzeugt, so beträgt der Flächenbedarf einer Speicherzelle 4 F². In dieser Ausführungsform der Erfindung wird ausgenutzt, daß die Justiergenauigkeit stets besser als die kleinste herstellbare Strukturgröße F ist. Bei einer 1-um-Technologie läßt sich damit eine Speicherzelle mit einer Fläche von 4 µm² herstellen. Damit werden Speicherdichten von 0,25 bit/µm² erzielt. Die erfindungsgemäß hergestellte Festwert-Speicherzellenanordnung ist daher zur Abspeicherung hoher Datenmengen geeignet. Sie ist damit eine attraktive Alternative zu einem herkömmlichen Compact Diskspeicher, da die erfindungsgemäße Anordnung einen wahlfreien Zugriff auf die gespeicherte Information erlaubt, da sie zum Auslesen kein mechanisches Laufwerk und damit weniger elektrische Leistung erfordert und da sie auch für mobile Systeme einsetzbar ist.

Bei der Herstellung einer Speicherzellenanordnung mit 4 F²-Speicherzellen ist es vorteilhaft, die Löcher in Bezug auf die Mitte der Isolationsgräben um etwa eine halbe Breite der Isolationsgräben versetzt anzuordnen, da dann die Isolation zwischen benachbarten Speicherzellen am größten ist.

Es liegt im Rahmen der Erfindung, bei der Herstellung des Zellenfeldes der Speicherzellenanordnung gleichzeitig MOS-Transistoren zur Ansteuerung der Speicherzellenanordnung in der Peripherie auf dem Substrat zu bilden. Das Gateoxid und die Gateelektroden der MOS-Transistoren in der Peripherie können dabei in den gleichen Prozeßschritten wie das Gateoxid und die Gateelektroden im Zellenfeld gebildet werden.

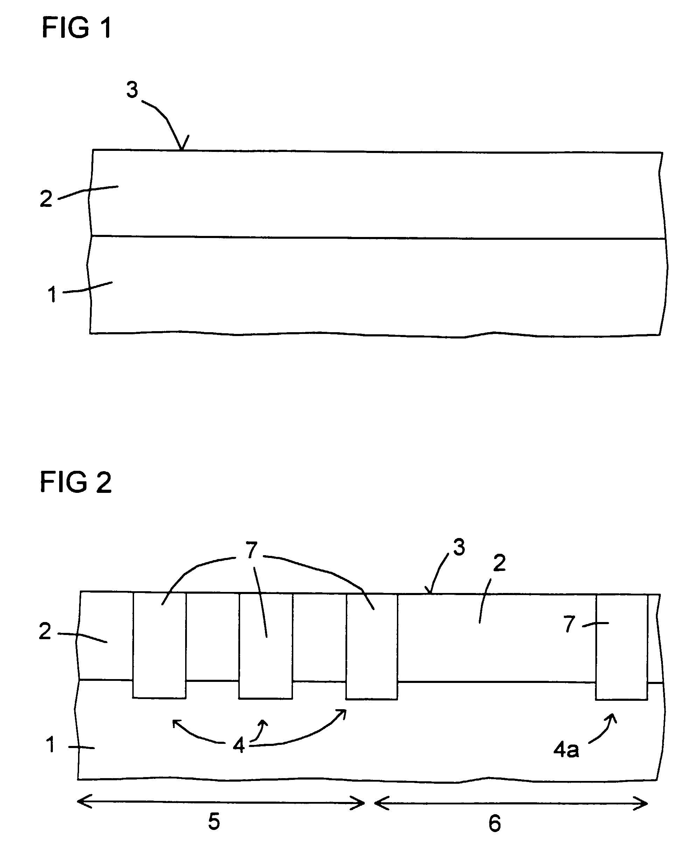

Im folgenden wird die Erfindung anhand eines Ausführungsbeispiels und der Figuren näher erläutert.
- Figur 1: zeigt ein Substrat mit einem ersten dotierten Gebiet.
- Figur 2: zeigt das Substrat nach der Herstellung von Isolationsgräben.
- Figur 3: zeigt das Substrat mit einer Maske, die ein Gebiet für eine Peripherie abdeckt.
- Figur 4: zeigt das Substrat nach der Bildung eines zweiten dotierten Gebietes und einer isolierenden Schicht an der Oberfläche des zweiten dotierten Gebietes.
- Figur 5: zeigt das Substrat nach der Öffnung von Löchern für vertikale MOS-Transistoren und der Bildung eines Gateoxids.
- Figur 6: zeigt das Substrat nach Erzeugung einer dotierten Polysiliziumschicht.
- Figur 7: zeigt das Substrat nach Strukturierung der dotierten Polysiliziumschicht in Wortleitungen und Gateelektroden für MOS-Transistoren in der Peripherie sowie nach Erzeugung von Source/Drain-Gebieten für die MOS-Transistoren der Peripherie.
- Figur 8: zeigt eine Aufsicht auf ein Zellenfeld einer nach dem erfindungsgemäßen Verfahren hergestellten Speicherzellenanordnung.
Auf einem Substrat 1 aus zum Beispiel n-dotiertem monokristallinem Silizium mit einer Dotierstoffkonzentration von 1 x 10¹⁹ cm⁻³ wird ein erstes dotiertes Gebiet 2 erzeugt. Das erste dotierte Gebiet 2 wird zum Beispiel p-dotiert mit einer Dotierstoffkonzentration von zum Beispiel 5 x 10¹⁶ cm⁻³ (siehe Figur 1). Das erste dotierte Gebiet 2 wird zum Beispiel durch eine ganzflächige oder maskierte Implantation mit Bor oder durch Aufwachsen von einer in situ p-dotierten Schicht mittels einer CVD-Epitaxie hergestellt. Das erste dotierte Gebiet 2 umfaßt eine Hauptfläche 3. Senkrecht zur Hauptflache 3 weist das erste dotierte Gebiet 2 eine Dicke von zum Beispiel 0,5 um bis 1 µm auf.

Unter Verwendung einer Grabenmaske, die auf die Hauptfläche 3 aufgebracht wird und die der Übersichtlichkeit halber nicht dargestellt ist, werden in einem anisotropen Trockenätzverfahren Gräben 4 geätzt (siehe Figur 2). In denjenigem Teil des Substrats 1, in dem im weiteren ein Zellenfeld 5 gebildet wird, verlaufen die Gräben 4 streifenförmig über die Hauptfläche 3. Die Gräben 4 weisen eine Tiefe von zum Beispiel 0,5 bis 1 µm auf. Sie reichen bis in das n-dotierte Substrat 1 hinein. Parallel zur Hauptflache 3 weisen die Gräben 4 eine Breite von einer minimalen Strukturgröße F, zum Beispiel 0,6 µm, auf und eine Länge von zum Beispiel 100 µm. Im Bereich des Zellenfeldes 5 sind zum Beispiel 16.000 Gräben parallel nebeneinander angeordnet. Der Abstand zwischen benachbarten Gräben 4 beträgt wiederum eine minimale Strukturgröße, zum Beispiel 0,6 µm.

Außerhalb des Zellenfeldes 5 wird in dem Substrat im weiteren eine Peripherie gebildet. Bei der Grabenätzung werden im Bereich der Peripherie 5 ebenfalls Gräben 4a erzeugt, die später zur Isolation von in der Peripherie 6 herzustellenden Schaltungsteilen verwendet werden.

Anschließend werden die Gräben 4, 4a mit isolierendem Material gefüllt. Dazu wird zum Beispiel eine thermische Oxidation bei 900°C durchgeführt, bei der eine SiO₂-Schicht in einer Dicke von etwa 40 nm entsteht. Anschließend wird in einem TEOS-Verfahren eine weitere SiO₂-Schicht mit im wesentlichen konformer Kantenbedeckung abgeschieden. Die weitere SiO₂-Schicht wird in einer solchen Dicke abgeschieden, daß die Gräben 4, 4a vollständig aufgefüllt werden. Anschließend werden die weitere SiO₂-Schicht und die SiO₂-Schicht in einem zu Silizium selektiven Ätzverfahren, zum Beispiel mit CHF₃, CF₄, Ar rückgeätzt, bis die Oberfläche des ersten dotierten Gebietes 2 freigelegt wird. Auf diese Weise werden die Gräben 4, 4a mit einer Grabenisolation 7 aus SiO₂ aufgefüllt.

Anschließend wird auf die Hauptflache 3 ganzflächig eine dünne SiO₂-Schicht 8 und eine Si₃N₄-Schicht 9 aufgebracht. Die SiO-Schicht 8 wird in einer Dicke von zum Beispiel 20 nm und die Si₃N₄-Schicht 9 in einer Dicke von zum Beispiel 100 nm erzeugt. Es wird eine Maske 10 aus zum Beispiel Photolack erzeugt, die die Peripherie 6 abdeckt, während das Zellenfeld von der Maske 10 unbedeckt bleibt. Unter Verwendung der Maske 10 als Ätzmaske wird in einem anisotropen Trockenätzprozeß die Si₃N₄-Schicht 9 und die SiO₂-Schicht 8 strukturiert, so daß die Hauptfläche 3 im Bereich des Zellenfeldes 5 freigelegt wird.

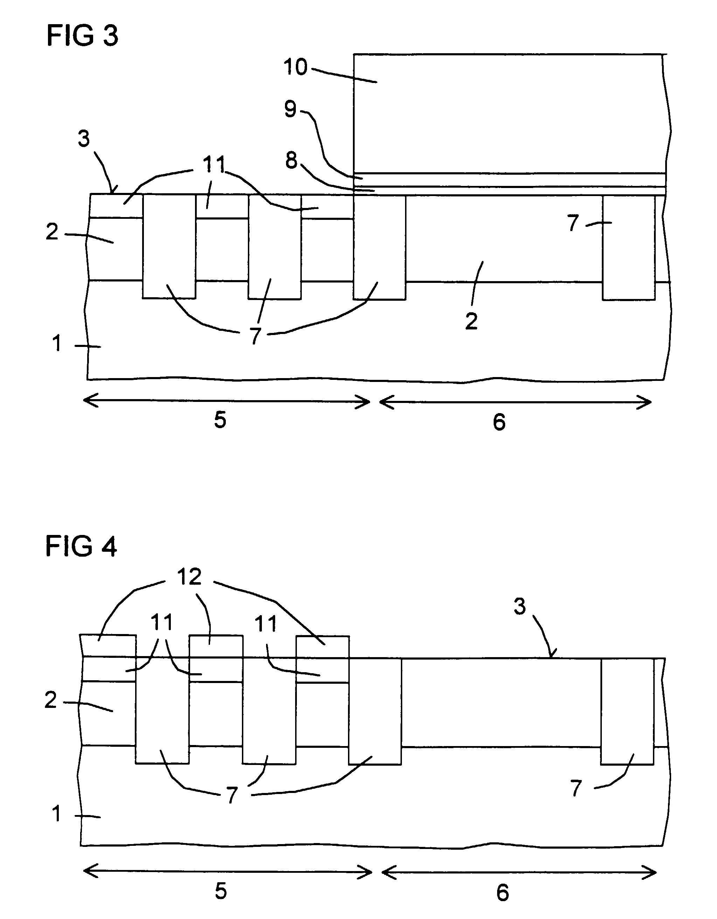

Durch eine Implantation mit Arsen bei einer Implantationsenergie von 50 keV und einer Dosis von 5 x 10¹⁵ cm⁻² wird zwischen den Grabenisolationen 7 jeweils ein streifenförmiges zweites dotiertes Gebiet 11 erzeugt, das n⁺-dotiert ist mit einer Dotierstoffkonzentration von 10²¹cm⁻³. Die Tiefe des zweiten dotierten Gebietes 11 senkrecht zur Hauptfläche 3 beträgt jeweils etwa 0,2 µm (siehe Figur 3).

Nach Entfernen der Maske 10 wird eine thermische Oxidation bei 850°C in feuchter Atmosphäre durchgeführt. Dabei entsteht an der Oberfläche der zweiten dotierten Gebiete 11 selbstjustiert eine isolierende Schicht 12 aus SiO₂. Die isolierende Schicht 12 weist eine Dicke von etwa 400 nm auf (siehe Figur 4).

Um die Planarität im Zellenfeld 5 zu verbessern, kann vor der Implantation zur Bildung der zweiten dotierten Gebiete 11 eine zu SiO₂ selektive Siliziumätzung mit zum Beispiel HBr, Cl₂, He durchgeführt werden. Dabei wird im Zellenfeld die Höhe des ersten dotierten Gebietes 2 um etwa die halbe Dicke der später herzustellenden isolierenden Schicht 12 reduziert. Bei der thermischen Oxidation zur selbstjustierten Bildung der isolierenden Schicht 12 an der Oberfläche der zweiten dotierten Gebiete 11 wird dann die beim Rückätzen entstandene Stufe durch das Aufquellen des Materials bei der Oxidation ausgeglichen, so daß im Zellenfeld eine planare Oberfläche erzielt wird. Der Übersichtlichkeit halber sind diese Schritte nicht im einzelnen dargestellt.

Nach der Bildung der isolierenden Schicht 12 werden in der Peripherie 6 die Siliziumnitridschicht 9 und die SiO₂-Schicht 8 zum Beispiel mit CHF₃, O₂ bzw. CHF₃, CF₄, Ar entfernt.

Es wird eine Maske erzeugt, die die Peripherie 6 vollständig abdeckt und die im Zellenfeld den Ort für Löcher definiert. In einem anisotropen Ätzprozeß, zum Beispiel mit Ar werden anschließend Löcher 13 geätzt, die jeweils an eine Grabenisolation 7 angrenzen und diese teilweise überlappen. In diesem Ätzprozeß wird das Zellenfeld 5 programmiert. Die Löcher 13 weisen parallel zur Hauptfläche 3 einen im wesentlichen quadratischen Querschnitt mit einer Seitenlänge von einer minimalen Strukturgröße F, zum Beispiel 0,6 um auf. Bezüglich der Mitte der jeweils benachbarten Grabenisolation sind die Löcher 13 um F/2 versetzt angeordnet. Dabei wird ausgenutzt, daß in heutigen Technologien die Justiergenauigkeit stets besser ist als die minimale Strukturgröße F. Die Löcher 13 reichen bis in das n-dotierte Substrat 1 hinein. Sie weisen eine Tiefe von zum Beispiel 1 µm auf.

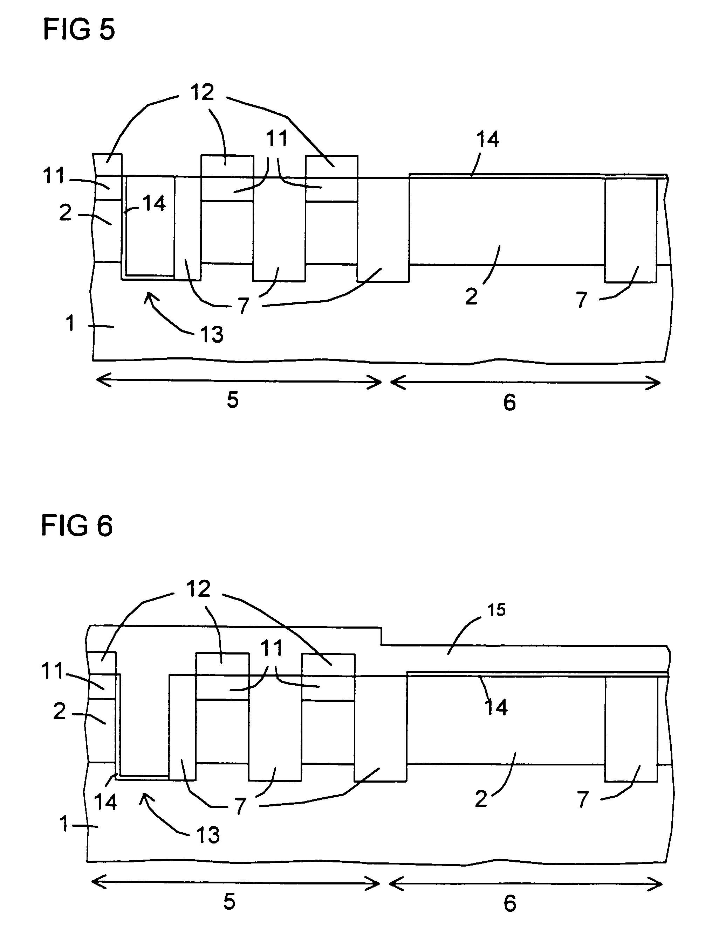

Nach Entfernen der Maske wird eine thermische Oxidation bei zum Beispiel 750°C durchgeführt. Dabei entsteht an freiliegenden Siliziumflächen ein Gateoxid 14. Das Gateoxid 14 entsteht dabei sowohl an den freiliegenden Siliziumflächen, die die Flanken und den Boden der Löcher 13 bilden als auch in der Peripherie 6 an der freiliegenden Oberfläche des ersten dotierten Gebietes 2. Wegen der unterschiedlichen Dotierung wächst das Gateoxid 14 in den Löchern 13 auf der Oberfläche des ersten dotierten Gebietes 2 mit geringerer Dicke auf als auf der Oberfläche des Substrats 1 sowie des zweiten dotierten Gebietes 11. An der Oberfläche des ersten dotierten Gebietes 2 wird das Gateoxid 14 in einer Dicke von zum Beispiel 15 nm, an der Oberfläche des Substrats 1 und des zweiten dotierten Gebietes 11 in einer Dicke von ca. 30 nm erzeugt (siehe Figur 5).

Es wird eine Implantation mit zum Beispiel Bor durchgeführt. Dabei beträgt die Implantationsenergie zum Beispiel 25 keV und die Dosis zum Beispiel 1 x 10¹² cm⁻². Durch diese Implantation wird die Einsatzspannung von im folgenden in der Peripherie 6 herzustellenden MOS-Transistoren eingestellt.

Anschließend wird ganzflächig eine leitfähige Schicht 15 aus zum Beispiel dotiertem Polysilizium abgeschieden. Die leitfähige Schicht 15 wird mit im wesentlichen konformer Kantenbedeckung abgeschieden. Die Dicke der leitfähigen Schicht 15 wird so eingestellt, daß die Löcher 13 vollständig aufgefüllt werden. Die Abscheidung der leitfähigen Schicht 15 erfolgt zum Beispiel in einem CVD-Verfahren mit SiH₄, wobei dem Prozeßgas als Dotierstoff Phosphor beigegeben wird. Die leitfähige Schicht 15 wird in einer Dicke von zum Beispiel 400 nm abgeschieden (siehe Figur 6).

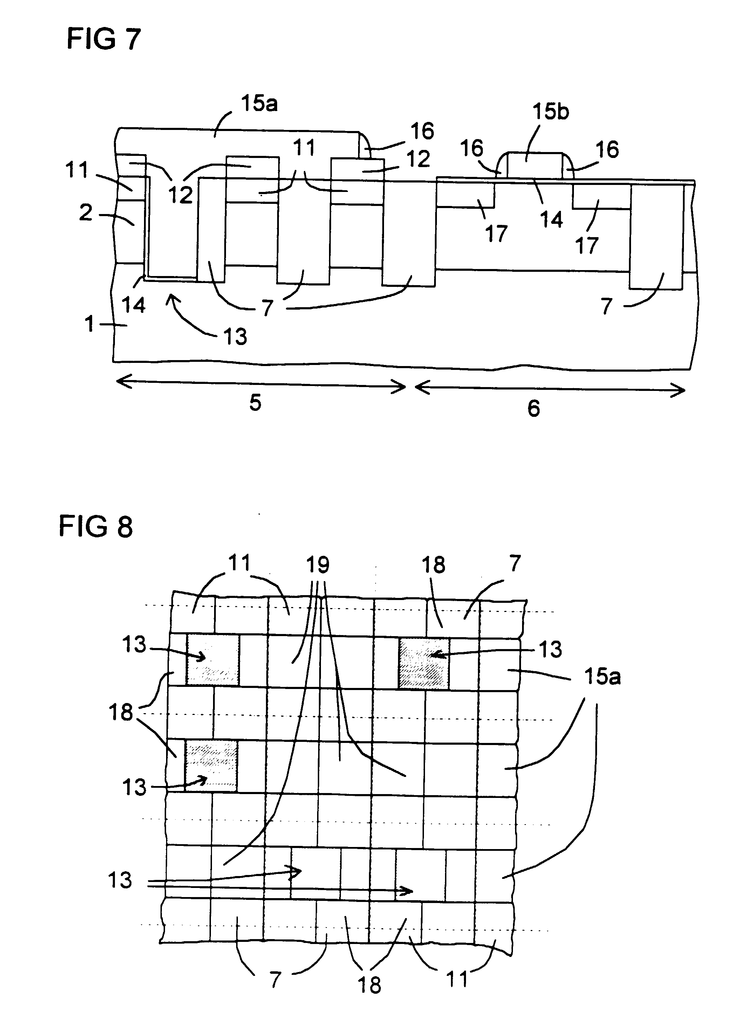

Es wird eine Photolackmaske (nicht dargestellt) erzeugt. Unter Verwendung der Photolackmaske als Ätzmaske wird die leitfähige Schicht 15 in einem anisotropen Ätzprozeß, zum Beispiel mit HBr, Cl₂ strukturiert (siehe Figur 7). Dabei werden im Bereich des Zellenfeldes 5 aus der leitfähigen Schicht 15 Wortleitungen 15a gebildet. Gleichzeitig werden im Bereich der Peripherie 6 Gateelektroden 15b für MOS-Transistoren gebildet.

Die Wortleitungen 15a verlaufen quer zu den Grabenisolationen 7. Der in den Löchern 13 angeordnete Teil der Wortleitungen 15a bildet jeweils eine Gateelektrode für den aus Substrat 1, erstem dotiertem Gebiet 2, zweitem dotiertem Gebiet 11 und an der Flanke des jeweiligen Lochs 13 angeordneten Gatedielektrikum 14 gebildeten MOS-Transistor. Die Gateelektroden dieser vertikalen MOS-Transistoren sind herstellungsbedingt mit der jeweiligen Wortleitung 15a verbunden.

Zur Fertigstellung von lateralen MOS-Transistoren in der Peripherie 6 werden anschließend durch konforme Abscheidung und anisotrope Ätzung einer SiO₂-Schicht an senkrechten Flanken der Wortleitungen 15a sowie der Gateelektroden 15b SiO₂-Spacer 16 erzeugt. Durch Implantation mit zum Beispiel Arsen bei einer Energie von 50 keV und einer Dosis von 5 x 10¹⁵ cm⁻² werden in der Peripherie 6 Source/Drain-Gebiete 17 gebildet. Da die Source/Drain-Gebiete 17 der MOS-Transistoren in der Peripherie 6 vom gleichen Leitfähigkeitstyp dotiert sind wie die Gateelektrode 15b und die Wortleitungen 15a, kann diese Implantation ohne zusätzliche Maske erfolgen.

Zur Herstellung der lateralen MOS-Transistoren in der Peripherie 6 können weitere, aus der MOS-Technik bekannte Verfahrensschritte wie LDD-Profil, Salicide-Technik und ähnliches durchgeführt werden.

Zur Fertigstellung der Festwertspeicherzellenanordnung wird anschließend ganzflächig eine planarisierende Zwischenoxidschicht zum Beispiel aus Bor-Phosphor-Silikatglas abgeschieden, in der Kontaktlöcher geöffnet werden. Die Kontaktlöcher werden zum Beispiel mit Wolfram aufgefüllt. Es folgt die Erzeugung einer Metallisierungsebene zum Beispiel durch Abscheidung und Strukturierung einer Aluminiumschicht. Schließlich wird eine Passivierungsschicht aufgebracht. Dabei wird auch das Substrat 1 mit einem Kontakt versehen. Diese Standardschritte sind nicht im einzelnen dargestellt.

In der erfindungsgemäß hergestellten Festwertspeicherzellenanordnung wird das Substrat 1, das n-dotiert ist, als gemeinsame Referenzleitung verwendet, die mit den Sourcegebieten der vertikalen MOS-Transistoren im Zellenfeld 5 verbunden ist. Die jeweils zwischen benachbarten Grabenisolationen 7 angeordneten streifenförmigen Teile des ersten dotierten Gebietes 2, das p-dotiert ist, wird als Kanalgebiet für die vertikalen MOS-Transistoren verwendet. Die zweiten dotierten Gebiete 11, die jeweils streifenförmig zwischen benachbarten Grabenisolationen 7 verlaufen, werden als Bitleitungen verwendet.

Figur 8 zeigt eine Aufsicht auf das Zellenfeld 5 der erfindungsgemäß hergestellten Festwertspeicherzellenanordnung. Die Festwertspeicherzellenanordnung umfaßt im Zellenfeld 5 erste Speicherzellen 18 sowie zweite Speicherzellen 19. Die Zellengröße der ersten Speicherzellen 18 und der zweiten Speicherzellen 19 sind in Figur 8 als strichpunktierte Linien eingetragen. In den ersten Speicherzellen 18 ist jeweils ein erster logischer Wert, in den zweiten Speicherzellen 19 ein zweiter logischer Wert gespeichert. Der erste logische Wert wird in den ersten Speicherzellen 18 dadurch eingeschrieben, daß im Bereich der ersten Speicherzellen 18 durch Ätzung des Loches 13 und Bildung von Gateoxid 14 und Gateelektrode 15 ein vertikaler MOS-Transistor gebildet wird, dessen Gateelektrode mit einer der Wortleitungen 15a verbunden ist.

Der zweite logische Wert wird in den zweiten Speicherzellen 19 dadurch eingeschrieben, daß im Bereich der zweiten Speicherzellen 19 kein Loch geätzt wird und damit im weiteren Herstellungsverfahren kein vertikaler MOS-Transistor entsteht. Die über die zweiten Speicherzellen 19 verlaufenden Wortleitungen 15a sind damit im Bereich der zweiten Speicherzellen 19 nicht mit einer vertikalen Gateelektrode verbunden. Dadurch kann bei Auswahl einer zweiten Speicherzelle 19 über die entsprechende Wortleitung 15a kein Strom über die entsprechenden Bitleitung 11 fließen.

In dem erfindungsgemäßen Herstellungsverfahren werden sieben Masken benötigt, wobei gleichzeitig mit dem Zellenfeld 5 laterale Transistoren in der Peripherie 6 hergestellt werden. Der Flächenbedarf einer Speicherzelle 18, 19 beträgt in diesem Ausführungsbeispiel 4 F², wobei F die in der jeweiligen Lithographie kleinste herstellbare Strukturgröße ist.

## Patentansprüche

1. Verfahren zur Herstellung einer Festwertspeicherzellenanordnung,
- bei dem an einer Hauptfläche (3) eines Halbleitersubstrats (1) ein Zellenfeld (5) mit ersten Speicherzellen (18), in denen ein erster logischer Wert gespeichert ist und die mindestens einen zur Hauptfläche (3) vertikalen MOS-Transistor umfassen, und zweite Speicherzellen (19), in denen ein zweiter logischer Wert gespeichert ist und die keinen MOS-Transistor umfassen, gebildet wird,
- bei dem das Halbleitersubstrat (3) von einem ersten Leitfähigkeitstyp dotiert ist und mit einem ersten dotierten Gebiet (2), das von einem zweiten, zum ersten entgegengesetzten Leitfähigkeitstyp dotiert wird und das im Bereich des Zellenfeldes (5) an die Hauptfläche (3) angrenzt, versehen wird,
- bei dem mehrere, im wesentlichen parallel verlaufende, streifenförmige Isolationsgräben (7) erzeugt werden, die mit isolierendem Material gefüllt sind und die von der Hauptfläche (3) durch das erste dotierte Gebiet (2) bis in den unterhalb des ersten dotierten Gebietes (2) angeordneten Teil des Halbleitersubstrats (1) hineinreichen,
- bei dem ein zweites, vom ersten Leitfähigkeitstyp dotiertes Gebiet (11) erzeugt wird, das eine geringere Tiefe als das erste dotierte Gebiet (2) aufweist und das an die Hauptfläche (3) angrenzt,
- bei dem zur Bildung vertikaler MOS-Transistoren Löcher (13) geöffnet werden, die von der Hauptfläche (3) durch das erste dotierte Gebiet (2) bis in den unterhalb des ersten dotierten Gebietes (2) angeordneten Teil des Halbleitersubstrats (1) hineinreichen, die die Grenzfläche zwischen einem der Isolationsgräben (7) und dem benachbarten Teil des zweiten dotierten Gebietes (2) überlappen und deren Oberfläche mit einem Gatedielektrikum (14) versehen wird,
- bei dem im Zellenfeld (5) die Oberfläche der zweiten dotierten Gebiete (11) mit einer isolierenden Schicht (12) versehen wird,
- bei dem zur Bildung einer Gateelektrode ganzflächig eine leitfähige Schicht (15) mit im wesentlichen konformer Kantenbedeckung abgeschieden wird, die die Löcher (13) im wesentlichen auffüllt und die so strukturiert wird, daß streifenförmige Wortleitungen (15a) entstehen, die quer zu den Isolationsgräben (7) verlaufen.

2. Verfahren nach Anspruch 1,
- bei dem die Isolationsgräben (7) in solchen Abständen und mit solchen Breiten erzeugt werden, daß der Abstand zwischen benachbarten Isolationsgräben (7) im wesentlichen gleich der Breite der Isolationsgräben (7) ist,
- bei dem die Löcher (13) mit einem Querschnitt parallel zur Hauptfläche (3) mit linearen Abmessungen im wesentlichen gleich der Breite der Isolationsgräben (7) hergestellt werden,
- bei dem der Mittelpunkt des Querschnitts der Löcher (13) im Bezug auf die Mitte der Isolationsgräben (7) versetzt angeordnet wird.

3. Verfahren nach Anspruch 2,
bei dem der Mittelpunkt des Querschnitts der Löcher (13) in Bezug auf die Mitte der Isolationsgräben (7) um etwa eine halbe Breite der Isolationsgräben (7) versetzt angeordnet wird.

4. Verfahren nach einem der Ansprüche 1 bis 3,
bei dem zur Bildung der Isolationsgräben (7) unter Verwendung einer Grabenmaske in einem anisotropen Trockenätzprozeß Gräben (4) geätzt werden, die mit isolierendem Material aufgefüllt werden.

5. Verfahren nach Anspruch 4,
- bei dem die Löcher (13) durch anisotropes Trockenätzen unter Verwendung einer Lochmaske geätzt werden,
- bei dem zur Bildung des Gateoxids (14) eine thermische Oxidation durchgeführt wird.

6. Verfahren nach Anspruch 5,
- bei dem auf die Hauptfläche (3) ganzflächig eine Doppelschicht (8, 9) aus SiO₂ und Si₃N₄ aufgebracht wird,
- bei dem die Doppelschicht (8, 9) nach der Implantation zur Bildung der zweiten dotierten Gebiete (11) im Bereich des Zellenfeldes (5) entfernt wird,
- bei dem die isolierende Schicht (12) an der Oberfläche der zweiten dotierten Gebiete durch eine thermische Oxidation gebildet wird, wobei eine Oxidation der Oberfläche außerhalb des Zellenfeldes (5) durch die Doppelschicht (8, 9) verhindert wird,
- bei dem die Doppelschicht (8, 9) nach der Bildung der isolierenden Schicht (12) entfernt wird.

7. Verfahren nach Anspruch 6,
bei dem vor dem Aufbringen der Doppelschicht (8, 9) im Bereich des Zellenfeldes (5) eine Silizium selektiv zu SiO₂ angreifende Ätzung durchführt wird.

8. Verfahren nach einem der Ansprüche 5 bis 7,
- bei dem bei der thermischen Oxidation zur Bildung des Gateoxids (14) gleichzeitig eine Gateoxidschicht für MOS-Transistoren in einer Peripherie (6) außerhalb des Zellenfeldes (5) gebildet werden,
- bei dem die leitfähige Schicht (15) so strukturiert wird, daß gleichzeitig Gateelektroden (15b) für die MOS-Transistoren in der Peripherie (6) gebildet werden.

9. Verfahren nach Anspruch 8,
- bei dem die Flanken der Gateelektroden (15b) der MOS-Transistoren in der Peripherie (6) mit Flankenisolationen (16) versehen werden,
- bei dem durch Implantation Source/Drain-Gebiete (17) für die MOS-Transistoren in der Peripherie (6) gebildet werden, wobei die mit Flankenisolationen (16) versehenen Gateelektroden (15b) als Maske verwendet werden.

## Claims

1. Method for production of a read-only-memory cell arrangement,
- in the case of which a cell field (5) is formed on a main surface (3) of a semiconductor substrate (1), which cell field (5) has first memory cells (18) in which a first logic value is stored and which comprise at least one MOS transistor which is vertical with respect to the main surface (3), and has second memory cells (19) in which a second logic value is stored and which do not comprise an MOS transistor,
- in the case of which the semiconductor substrate (3) is doped by a first conductance type and is provided with a first doped region (2) which is doped by a second conductance type, opposite to the first, and abuts the main surface (3) in the area of the cell field (5),
- in the case of which a plurality of insulation trenches (7) are produced which run essentially parallel, are in the form of strips, are filled with insulating material and extend from the main surface (3), through the first doped region (2), into that part of the semiconductor substrate (1), which is arranged below the first doped region (2),
- in the case of which a second region (11) is produced, which is doped by a first conductance type, has a shallower depth than the first doped region (2) and abuts the main surface (3),
- in the case of which, holes (13) are opened in order to form vertical MOS transistors, which holes (13) extend from the main surface (3), through the first doped region (2), into that part of the semiconductor substrate (1) which is arranged below the first doped region (2), overlap the boundary surface between one of the insulation trenches (7) and the adjacent part of the second doped region (2) and whose surface is provided with a gate dielectric (14),
- in the case of which the surface of the second doped regions (11) is provided with an insulating layer (12) in the cell field (5),
- in the case of which a conductive layer (15) with essentially conformal edge covering is deposited over the entire area for formation of a gate electrode, which conductive layer (15) essentially fills the holes (13) and is structured such that word lines (15a) are produced which are in the form of strips and run transversely with respect to the insulation trenches (7).

2. Method according to Claim 1,
- in the case of which the insulation trenches (7) are produced at such intervals and with such widths that the distance between adjacent insulation trenches (7) is essentially equal to the width of the insulation trenches (7),
- in the case of which the holes (13) are produced with a cross-section parallel to the main surface (3) with linear dimensions essentially equal to the width of the insulation trenches (7),
- in the case of which the centre point of the cross-section of the holes (13) is arranged offset with respect to the centre of the insulation trenches (7).

3. Method according to Claim 2, in the case of which the centre point of the cross-section of the holes (13) is arranged offset by approximately half the width of the insulation trenches (7) with respect to the centre of the insulation trenches (7).

4. Method according to one of Claims 1 to 3, in the case of which trenches (4), which are filled with insulating material, are etched in an anisotropic dry-etching process, using a trench mask, for formation of the insulation trenches (7).

5. Method according to Claim 4,
- in the case of which the holes (13) are etched by anisotropic dry etching using a perforated mask,
- in the case of which thermal oxidation is carried out for formation of the gate oxide (14).

6. Method according to Claim 5,
- in the case of which a double layer (8, 9) of SiO₂ and Si₃N₄ is applied to the main surface (3) over the entire area,
- in the case of which the double layer (8, 9) is removed in the region of the cell field (5), after the implantation for formation of the second doped regions (11),
- in the case of which the insulating layer (12) on the surface of the second doped regions is formed by thermal oxidation, any oxidation of the surface outside the cell field (5) being prevented by the double layer (8, 9),
- in the case of which the double layer (8, 9) is removed after the formation of the insulating layer (12).

7. Method according to Claim 6, in the case of which etching, which attacks silicon selectively with respect to SiO2, is carried out in the region of the cell field (5) before the application of the double layer (8, 9).

8. Method according to one of Claims 5 to 7,
- in the case of which, during the thermal oxidation for formation of the gate oxide (14), a gate oxide layer for MOS transistors is at the same time formed in a periphery (6) outside the cell field (5),
- in the case of which the conductive layer (15) is structured such that gate electrodes (15b) for the MOS transistors are at the same time formed in the periphery (6).

9. Method according to Claim 8,
- in the case of which the flanks of the gate electrodes (15b) of the MOS transistors in the periphery (6) are provided with flank insulations (16),
- in the case of which source-drain regions (17) for the MOS transistors in the periphery (6) are formed by implantation, the gate electrodes (15b), which are provided with flank insulations (16), being used as a mask.

## Revendications

1. Procédé de fabrication d'un groupement de cellules de mémoire morte,
- dans lequel on forme sur une surface principale (3) d'un substrat semi-conducteur (1), un champ de cellules (5) comprenant des premières cellules de mémoire (18) dans lesquelles une première valeur logique est mémorisée et qui comprennent au moins un transistor MOS vertical par rapport à la surface principale (3), et des deuxièmes cellules de mémoires (19) dans lesquelles une deuxième valeur logique est mémorisée et qui ne comprennent pas de transistor MOS,
- dans lequel le substrat semi-conducteur (3) est dopé avec un premier type de conductivité et est muni d'une première région dopée (2), qui est dopée avec un deuxième type de conductivité, inverse du premier, et qui est limitrophe à la surface principale (3) dans la région du champ de cellules (5),
- dans lequel on produit plusieurs fosses d'isolation (7) en forme de bandes s'étendant sensiblement parallèlement qui sont comblées d'une matière isolante et qui, en partant de la surface principale (3), s'enfoncent à travers la première région dopée (2) jusque dans la partie du substrat semiconducteur (1) qui est disposée au-dessous de la première région dopée (2),
- dans lequel on produit une deuxième région (11) dopée avec le premier type de conductivité, qui présente une plus faible profondeur que la première région dopée (2) et qui est limitrophe de la surface principale (3),
- dans lequel, pour la formation de transistors MOS verticaux, on ouvre des trous (13) qui, en partant de la surface principale (3) se creusent, en traversant la première région dopée (2), jusque dans la partie du substrat semi-conducteur (1) disposée au-dessous de la première région dopée (2), qui chevauchent sur la surface limite entre une des fosses d'isolation (7) et la partie adjacente de la deuxième région dopée (2) et dont la surface est munie d'un diélectrique de grille (14),
- dans lequel, dans le champ de cellules (5), la surface de la deuxième région dopée (11) est munie d'une couche isolante (12),
- dans lequel, pour la formation d'une électrode grille, on dépose sur toute la surface une couche conductrice (15) avec recouvrement des arêtes sensiblement conforme, qui comble sensiblement les trous (13) et qui est structurée de manière qu'il se forme des conducteurs de mots (15a) en forme de bandes qui s'étendent transversalement aux fosses d'isolation (7).

2. Procédé selon la revendication 1,
- dans lequel les fosses d'isolation (7) sont produites à des distances d'écartement telles et avec des largeurs telles que la distance d'écartement entre les fosses d'isolation (7) adjacentes soit sensiblement égale à la largeur des fosses d'isolation (7),
- dans lequel les trous (13) sont produits avec une section, parallèle à la surface principale (3), qui possède des dimensions linéaires sensiblement égales à la largeur des fosses d'isolation (7),
- dans lequel le centre de la section des trous (13) est décalé par rapport au centre des fosses d'isolation (13).

3. Procédé selon la revendication 2,
dans lequel le centre de la section des trous (13) est décalé par rapport au centre des fosses d'isolation (7) d'environ la moitié de la largeur des fosses d'isolation (7).

4. Procédé selon une des revendications 1 à 3,
dans lequel, pour la formation des fosses d'isolation (7), on grave, avec utilisation d'un masque de fosses et dans un processus de gravure à sec anisotrope, des fosses (4) qui sont comblées d'une matière isolante.

5. Procédé selon la revendication 4,
- dans lequel les trous (13) sont gravés par gravure à sec anisotrope avec utilisation d'un masque à trous,
- dans lequel, pour la formation de l'oxyde de grille (14), on effectue une oxydation thermique.

6. Procédé selon la revendication 5,
- dans lequel on dépose sur la surface principale (3), sur toute la surface, une double couche (8, 9) de SiO₂ et de Si₃N₄,
- dans lequel la double couche (8,9) est éliminée dans la zone du champ de cellules (5) après l'implantation servant pour la formation des deuxièmes régions dopées (11),
- dans lequel la couche isolante (12) est formée sur la surface des deuxièmes régions dopées par une oxydation thermique, l'oxydation de la surface en dehors du champ de cellules (5) étant empêchée par la double couche (8, 9),
- dans lequel la double couche (8, 9) est éliminée après la formation de la couche isolante (12).

7. Procédé selon la revendication 6,
- dans lequel, avant l'application de la double couche (8, 9), on effectue dans la zone du champ de cellules (5) une gravure qui attaque le silicium sélectivement pour le SiO₂.

8. Procédé selon une des revendications 5 à 7,
- dans lequel lors de l'oxydation thermique exécutée pour la formation de l'oxyde de grille (14), une couche d'oxyde de grille pour les transistors MOS est formée simultanément dans une périphérie (6) en dehors du champ de cellules (5),
- dans lequel la couche conductrice (15) est structurée de manière qu'il se forme simultanément des électrodes grilles (15b) pour les transistors MOS situés dans la périphérie (6).

9. Procédé selon la revendication 8,
- dans lequel les flancs des électrodes grilles (15b) des transistors MOS situés dans la périphérie (6) sont munis d'isolations de flancs (16),
- dans lequel des régions source/drain (17) pour les transistors MOS situés dans la périphérie (6) sont formées par implantation, les électrodes grilles (15b) munies des isolations de flancs (16) étant utilisées comme masque.
